# EUROPEAN PATENT APPLICATION

(11) **EP 3 407 136 A1**
(43) Date of publication of application: **28.11.2018**
(21) Application number: 16872985.3
(22) Date of filing: 06.12.2016
(51) Int. Cl.: G03F 7/20, G03F 9/00, H01L 21/68

(54) **EXPOSURE DEVICE, EXPOSURE DEVICE CONTROL METHOD, AND DEVICE MANUFACTURING METHOD**

(30) Priority: 07.12.2015 JP 2015238702
(71) Applicant: Nikon Corporation, Tokyo 108-6290 (JP)
(72) Inventor: SHIBAZAKI, Yuichi, Tokyo 108-6290 (JP)
(74) Representative: Hoffmann Eitle
(86) International application number: PCT/JP2016/086272
(87) International publication number: WO 2017/099087

(57) **Abstract**

An exposure apparatus (100) is equipped with: an irradiation device (30) that irradiates a target (W) with an electron beam; a stage (26) that holds the target; a stage driving system that includes an electromagnetic motor to drive the stage; and a control system that controls the stage driving system on the basis of an irradiation state of the electron beam on the target. The control system changes the control content with respect to the stage driving system between the irradiation time and the non-irradiation time of the electron beam on the target. Accordingly, it becomes possible to use the electromagnetic motor as a drive source of the stage and also to suppress the irradiation position displacement of the electron beam on the target at the time of driving of the stage.

## Description

### TECHNICAL FIELD

The present invention relates to exposure apparatuses and control methods of exposure apparatuses, and device manufacturing methods, and more particularly to an exposure apparatus that exposes a target with a charged particle beam and a control method of the exposure apparatus, and a device manufacturing method using the exposure apparatus.

### BACKGROUND ART

In recent years, in order to form a circuit pattern with a finer pitch than the resolution limit of an ultraviolet ray exposure apparatus, an electron beam exposure apparatus has been proposed that forms a smaller spot than the resolution limit of the ultraviolet ray exposure apparatus with an electron beam and relatively scans this spot of the electron beam and a target such as a wafer.

In the electron beam exposure apparatus, the high-speed deflection of the electron beam in an electron optical system is possible and the positional error of a stage that holds the target can be corrected on the optical system side. Consequently, in the electron beam exposure apparatus, the position control accuracy of the stage is not required to be as high as the accuracy of an optical exposure apparatus. Further, in the electron beam exposure apparatus, if an electromagnetic actuator such as a linear motor is employed for a stage driving, magnetic field fluctuation occurs when the electromagnetic actuator operates, and due to this magnetic field fluctuation, unexpected deflection or aberration of electron ray is generated, which decreases the exposure accuracy. Therefore, in a conventional electron beam exposure apparatus, an air stage is used to drive the target (e.g., refer to PTL1 and PTL2).

In the air stage, however, non-linear control error that is difficult to be corrected occurs at times and the controllability is inferior compared to an electromagnetic motor. Note that, in the case of using the electromagnetic motor, there is a method of shielding magnetism from the electromagnetic motor with a magnetic shield, but the complete shielding is difficult.

### CITATION LIST

### PATENT LITERATURE

[PTL 1] Japanese Patent Application Publication No. 2002-170765
[PTL 2] U.S. Patent No. 6,674,085

### SUMMARY OF INVENTION

According to a first aspect of the present invention, there is provided an exposure apparatus comprising an irradiation device that irradiates a target with a charged particle beam, the apparatus comprising: a stage that holds the target; a stage driving system that includes an electromagnetic motor to drive the stage; and a control system that controls the irradiation device and the stage driving system, wherein the control system controls the stage driving system based on an irradiation state of the charged particle beam on the target.

According to a second aspect of the present invention, there is provided an exposure apparatus that exposes a target with a charged particle beam while moving the target in a predetermined direction, the apparatus comprising: a stage that holds the target; an irradiation device that irradiates the target with the charged particle beam; a stage driving system that includes an electromagnetic motor to drive the stage; and a control system that drives the stage using the stage driving system at a time of acceleration/deceleration of the stage in the predetermined direction, and performs movement of the stage including a motion mainly according to the law of inertia at a time of constant speed movement of the stage in the predetermined direction.

According to a third aspect of the present invention, there is provided a device manufacturing method, comprising: exposing a substrate as a target with a charged particle beam, using either of the exposure apparatus related to the first aspect and the exposure apparatus related to the second aspect; and developing the substrate that has been exposed.

According to a fourth aspect of the present invention, there is provided a control method of an exposure apparatus comprising a stage that holds a target and an irradiation device that irradiates the target with a charged particle beam, the method comprising: controlling a stage driving system and the irradiation device, the stage driving system including an electromagnetic motor to drive the stage, wherein in the controlling, the stage driving system is controlled based on an irradiation state of the charged particle beam on the target.

According to a fifth aspect of the present invention, there is provided a control method of controlling an exposure apparatus that exposes a target with a charged particle beam from an irradiation device while moving the target in a predetermined direction, the method comprising: controlling a stage driving system that includes an electromagnetic motor to drive a stage that holds the target, wherein in the controlling, the stage is driven using the stage driving system at a time of acceleration/deceleration of the stage in the predetermined direction, and movement of the stage including a motion mainly according to the law of inertia is performed at a time of constant speed movement of the stage in the predetermined direction.

### BRIEF DESCRIPTION OF DRAWINGS

FIG. 1 is a view schematically showing the configuration of an electron beam exposure apparatus related to an embodiment.
FIG. 2 is a view enlargedly showing a lower end section of a barrel and a metrology frame shown in FIG. 1 with a partial section fractured, along with a stage.
FIG. 3 is a view showing an arrangement of reflected electron detecting devices, and also is a view showing a detection state of reflected electrons from an alignment mark.
FIG. 4 is a perspective view showing a stage device.
FIG. 5 is a view enlargedly showing the stage placed on a surface plate.
FIG. 6 is a view showing a state in which a fine movement stage and a magnetic shield member are removed from the stage shown in FIG. 4
FIG. 7 is a view used to explain the configuration of a self-weight cancelling device.
FIG. 8 is a block diagram showing the input/output relationship of a main controller that configures a control system of the electron beam exposure apparatus.
FIG. 9 is a view showing a block diagram of a stage controlling system structured inside a stage controller, along with the main controller.
FIG. 10 is a view showing an example of a movement route of a center of an exposure area with respect to a wafer at the time of exposure operation.
FIG. 11A and FIG. 11B are views respectively showing other examples of the movement route of the center of the exposure area with respect to a wafer at the time of exposure operation.
FIG. 12 is a flowchart used to explain an embodiment of a device manufacturing method.

### DESCRIPTION OF EMBODIMENTS

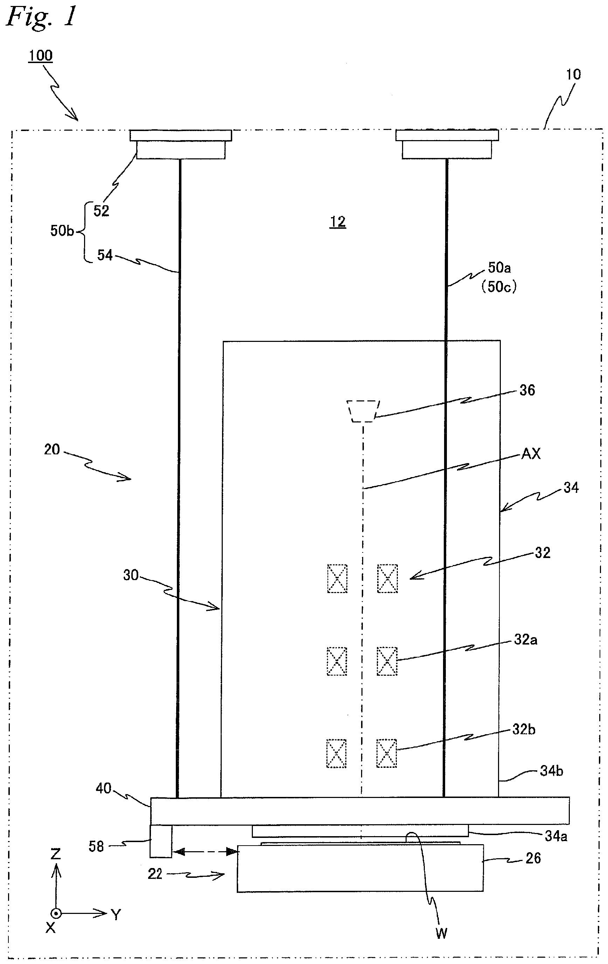

An embodiment will be described below, on the basis of FIGS. 1 to 11B.

FIG. 1 schematically shows the configuration of an electron beam exposure apparatus 100 related to the embodiment. Electron beam exposure apparatus 100 is equipped with an electron beam optical system as will be described later, and therefore, hereinafter, the Z-axis lies parallel to an optical axis of the electron beam optical system and the explanation is given assuming that a scanning direction in which a wafer W (a stage 26) is moved at the time of scanning exposure to be described later within a plane that is orthogonal to the Z-axis is a Y-axis direction, a direction orthogonal to the Z-axis and the Y-axis is an X-axis direction, and rotation (inclination) directions around the X-axis, the Y-axis and the Z-axis are a θx direction, a θy direction and a θz direction, respectively.

In the present embodiment, a configuration using an electron beam, as an example of a charged particle beam, will be described. However, the charged particle beam is not limited to the electron beam, and a beam using a charged particle such as an ion beam may be employed.

Electron beam exposure apparatus 100 is equipped with a vacuum chamber 10, and an exposure system 20 accommodated inside an exposure chamber 12 divided by vacuum chamber 10.

As illustrated in FIG. 1, exposure system 20 is equipped with: a stage device 22 including stage 26 that holds wafer W and is movable; and an electron beam irradiation device 30 having an electron beam optical system 32 that irradiates wafer W coated with resist (sensitive agent) for electron ray, with an electron beam.

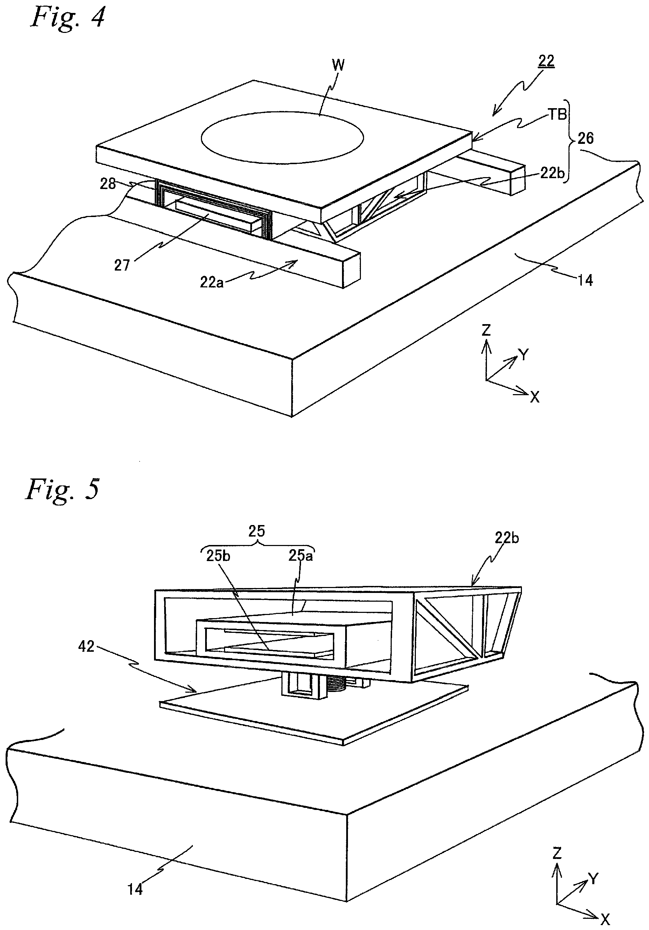

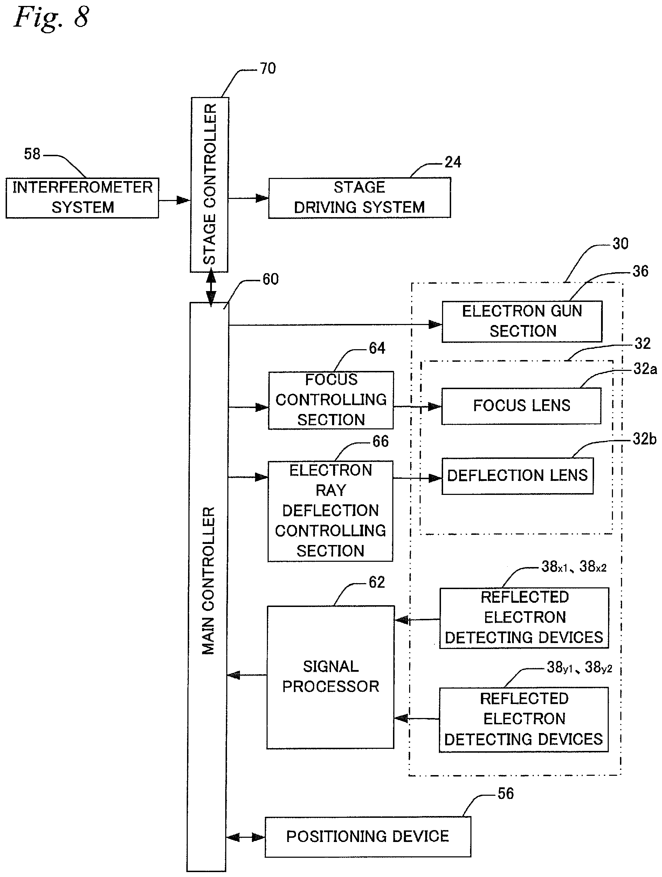

Stage 26 is driven with a predetermined stroke (such a stroke as to allow the electron beam to be irradiated on the entire surface of the wafer) in the X-axis direction and the Y-axis direction on a surface plate 14 (not illustrated in FIG. 1, see the figures such as FIGS. 4 and 5), and also finely driven in the Z-axis direction, the θx direction, the θy direction and the θz direction, by a stage driving system 24 (not illustrated in FIG. 1, see FIG. 8) including an electromagnetic motor and the like. In order to suppress as much as possible the irradiation position of the electron beam, emitted from electron beam irradiation device 30 to wafer W, from being shifted (displaced) because of the influence of the magnetic field fluctuation caused by the electromagnetic motor and the like, a magnetic shield is provided to the motor and the magnetic flux leakage from the motor to the wafer side is effectively suppressed. The specific configuration and the like of the stage device that includes the stage, the magnetic shield and the stage driving system will be described later in detail.

As illustrated in FIG. 1, electron beam irradiation device 30 has a barrel 34. Barrel 34 is formed into a cylindrical shape. Barrel 34 has: an electron beam emitting section 34a; a main body section 34b that houses an electron gun section and an electromagnetic lens to be described later; and a stepped section (a flange section) provided between electron beam emitting section 34a and main body section 34b. Barrel 34 is supported from below by a metrology frame 40 made up of an annular plate member. More specifically, electron beam emitting section 34a of barrel 34 is formed of a small diameter part whose diameter is small, compared to that of main body section 34b, and barrel 34 is supported from below by metrology frame 40 in a state where the small diameter part is inserted into a circular opening of metrology frame 40 and the bottom surface of the stepped section abuts the upper surface of metrology frame 40.

The lower ends of suspension support mechanisms 50a, 50b and 50c (in FIG. 1, however, suspension support mechanism 50c is hidden behind suspension support mechanism 50a on the depth side) that are three coupling members with a flexible structure are each connected, at an central angle of 120 degrees, to an outer circumference section of metrology frame 40, and metrology frame 40 is supported in a suspended state from a top plate (a ceiling wall) of vacuum chamber 10 that divides exposure chamber 12, via suspension support mechanisms 50a, 50b and 50c. That is, as is described above, electron beam irradiation device 30 is supported in a suspended manner at three points with respect to vacuum chamber 10.

As representatively shown by suspension support mechanism 50b in FIG. 1, the three suspension support mechanisms 50a, 50b and 50c each have a passive type vibration isolation pad 52 provided at its upper end, and a wire 54 made of steel having one end connected to the lower end of vibration isolation pad (vibration isolation section) 52 and the other end connected to metrology frame 40. Vibration isolation pads 52 are fixed to the top plate of vacuum chamber 10 and each include an air damper or a coil spring.

In the present embodiment, of vibration such as floor vibration transmitted from the outside to vacuum chamber 10, most part of a vibration component in the Z-axis direction parallel to an optical axis AX of electron beam optical system 32 is absorbed by vibration isolation pads 52, and therefore the high vibration damping performance can be obtained in a direction parallel to optical axis AX of electron beam optical system 32. Further, the natural frequencies of suspension support mechanisms 50a, 50b and 50c are lower in a direction perpendicular to optical axis AX of electron beam optical system 32, than those in the direction parallel to optical axis AX. Since the three suspension support mechanisms 50a, 50b and 50c vibrate as pendulum in the direction perpendicular to optical axis AX, the lengths of the three suspension support mechanisms 50a, 50b and 50c (the lengths of wires 54) are set sufficiently long so that the vibration damping performance in the direction perpendicular to optical axis AX (the capability to prevent vibration such as floor vibration transmitted from the outside to vacuum chamber 10 from travelling to electron beam irradiation device 30) is adequately high. With this structure, while the high vibration damping performance can be obtained and also large reduction in weight of a mechanism section is possible, there is a risk that the relative position between electron beam irradiation device 30 and vacuum chamber 10 is changed at a relatively low frequency. Therefore, in order to maintain the relative position between electron beam irradiation device 30 and vacuum chamber 10 in a predetermined state, a positioning device 56 of a noncontact method (not illustrated in FIG. 1, see FIG. 8) is provided between electron beam irradiation device 30 and vacuum chamber 10. This positioning device 56 can be configured including a hexaxial acceleration sensor and a hexaxial actuator, as disclosed in, for example, PCT International Publication No. WO 2007/077920 and the like. Positioning device 56 is controlled by a main controller 60 (see FIG. 8). Accordingly, the relative position in the X-axis direction, the Y-axis direction and the Z-axis direction and the relative rotation angle around the X-axis, the Y-axis and the Z-axis of electron beam irradiation device 30 with respect to vacuum chamber 10 are maintained in a constant state (a predetermined state).

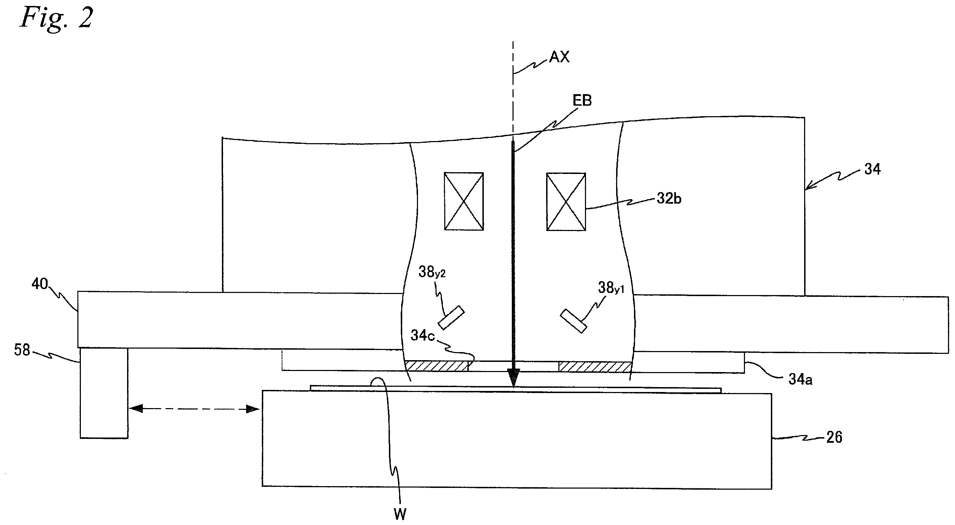

As illustrated in FIG. 1, electron beam irradiation device 30 includes: an electron gun section 36 at least a part of which is provided in barrel 34 and which forms an electron beam EB (see FIG. 2) by generating electrons and accelerating the electrons by an acceleration power source (not illustrated); electron beam optical system 32 that is configured of various types of electrodes such as electromagnetic lenses, apertures and the like, disposed in a predetermined relationship in barrel 34, for performing molding of the spot of electron beam EB, adjustment of the irradiation position of electron beam EB and adjustment of an irradiation amount with respect to wafer W; and the like. The electromagnetic lenses include an electromagnetic lens having a focus coil (hereinafter, referred to a focus lens for the sake of convenience), an electromagnetic lens having a deflection coil (hereinafter, referred to a deflection lens for the sake of convenience), and the like.

In FIG. 1, a focus lens 32a, a deflection lens 32b and the like, which configure electron beam optical system 32, are representatively illustrated. As shown in FIG. 8, focus lens 32a is controlled by main controller 60 via a focus controlling section 64, and deflection lens 32b is controlled by main controller 60 via an electron ray deflection controlling section 66.

In the present embodiment, electron beam optical system 32 is made up of a multibeam optical system that is capable of irradiating the n-number ("n" is, for example, 500) of beams that can be individually set to ON/OFF and can be deflected. As the multibeam optical system, such an optical system can be used that has a configuration similar to an optical system disclosed in, for example, Japanese Patent Application Publication No. 2011-258842, PCT International Publication No. WO 2007/017255 and the like. As an example, when 500 multibeams arrayed in a row in a lateral direction (the X-axis direction) are all set to the ON state (a state where the electron beams are irradiated on wafer W), a circular spot of the electron beam is simultaneously formed at 500 points set at equal intervals within an exposure area (an slit-shaped area elongated in the X-direction) of, for example, 10µm × 20nm. That is, one exposure area is formed by 500 points of electron beams. Note that the circular spot of the electron beam is formed with a smaller diameter (e.g., a diameter of 20nm) than the resolution limit of the ultraviolet ray exposure apparatus.

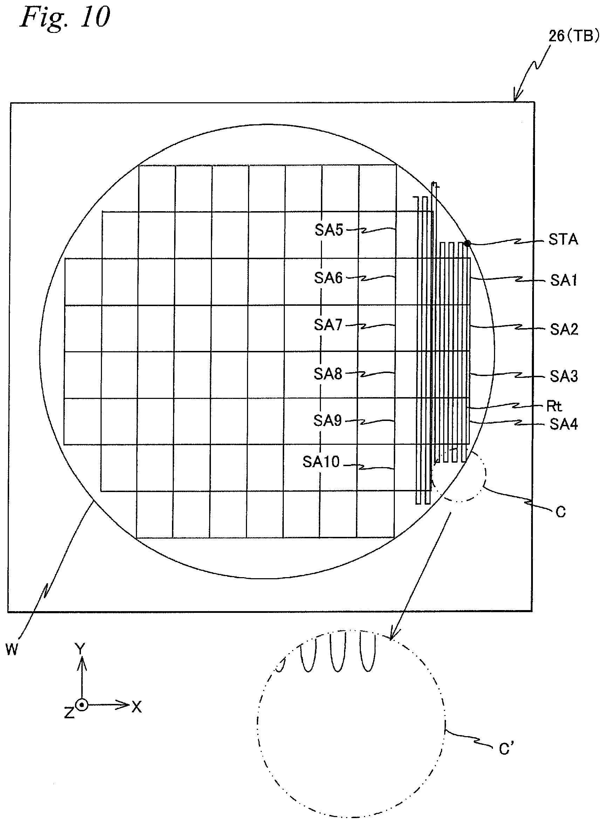

In the present embodiment, electron beam optical system 32 forms the spots of multiple (n=500) electron beams into a circular shape as is described above, and arranges these circular spots within the exposure area, and sets the electron beams to ON/OFF while moving stage 26 at a constant speed with a predetermined stroke in a predetermined direction, for example, the Y-axis direction so that wafer W is scanned with respect to this exposure area and also while deflecting the circular spots of the multiple electron beams, and thereby exposure (scanning exposure) of a part of a predetermined number of shot areas lying side by side in the Y-axis direction on wafer W (in FIG. 10, a first shot area row (four shot areas SA1 to SA4) located at the +X end), i.e., exposure (scanning exposure) of a band-shaped area with a width of 10µm is performed. A route Rt illustrated in FIG. 10 shows a route of the center of the exposure area.

Then, by repeating an alternate scan operation and a stepping operation, patterns are formed in the first shot area row on wafer W. In the alternate scan operation, the scanning exposure is performed by setting the movement direction of the stage alternately in the +Y direction and the -Y direction. In the stepping operation, wafer W (stage 26) is moved toward one side in the X-axis direction along a same distance as a size of the exposure area in the X-axis direction, during a deceleration and acceleration of wafer W (stage 26) in the Y-axis direction for the scan direction change in the alternate scan operation. Note that the position indicated by a reference sign "STA" in FIG. 10 shows an exposure starting position (an acceleration starting position) at which the exposure area is positioned prior to staring the acceleration of stage 26 for exposure of a first shot area on the start of the exposure operation.

Note that, in FIG. 10, wafer W is shown as if fixed and the center of the exposure area is shown as if moved with respect to the fixed wafer W, but in actuality the exposure area is fixed and wafer W (stage 26) is moved with respect to the fixed exposure area in a direction reversed to route Rt illustrated in FIG. 10.

Here, in the forgoing alternate scan operation, the stepping operation of stage 26 between plus scan with the +Y direction serving as the movement direction of stage 26 and minus scan with the -Y direction serving as the movement direction of stage 26 is started after the constant speed movement of stage 26 in the +Y direction is finished, and is performed by the acceleration in the -Y direction after the deceleration in the +Y direction of stage 26, and by the movement in the +X direction of stage 26 that is performed in parallel with this acceleration. Therefore, the trajectory (route) of the exposure area center with respect to wafer W at the time of this stepping operation is a U-shaped trajectory (route), as shown in a circle C' in which a part of the trajectory at the time of the stepping operation shown in a circle C of FIG. 10 is enlargedly shown. The stepping operation of stage 26 between the minus scan and the plus scan is similarly performed.

After the exposure (pattern formation) with respect to the first shot area row has been finished, stage 26 is not stopped, and the exposure operations with respect to a second shot area row including shot areas SA5 to SA10 and the subsequent shot area rows are performed in a similar manner to the exposure operation of the first shot area row.

In FIG. 2, the lower end of barrel 34 and metrology frame 40 shown in FIG. 1 are enlargedly illustrated with a partial section fractured, together with stage 26. On the bottom wall of barrel 34, an opening 34c serving as a passage of electron beam EB is formed near the central portion of electron beam emitting section 34a. Inside barrel 34, as illustrated in FIG. 2, a plurality of reflected electron detecting devices 38 that detect reflected electrons or secondary electrons are provided below deflection lens 32b of electron beam optical system 32. Each of the plurality of reflected electron detecting devices 38 is configured of, for example, a semiconductor detector, and sends the detection signal corresponding to the reflected electron that has been detected to a signal processor 62 (see FIG. 8). Signal processor 62 performs signal processing after amplifying the detection signals of the plurality of reflected electron detecting devices 38 by an amplifier (not illustrated), and sends the processing results to main controller 60 (see FIG. 8).

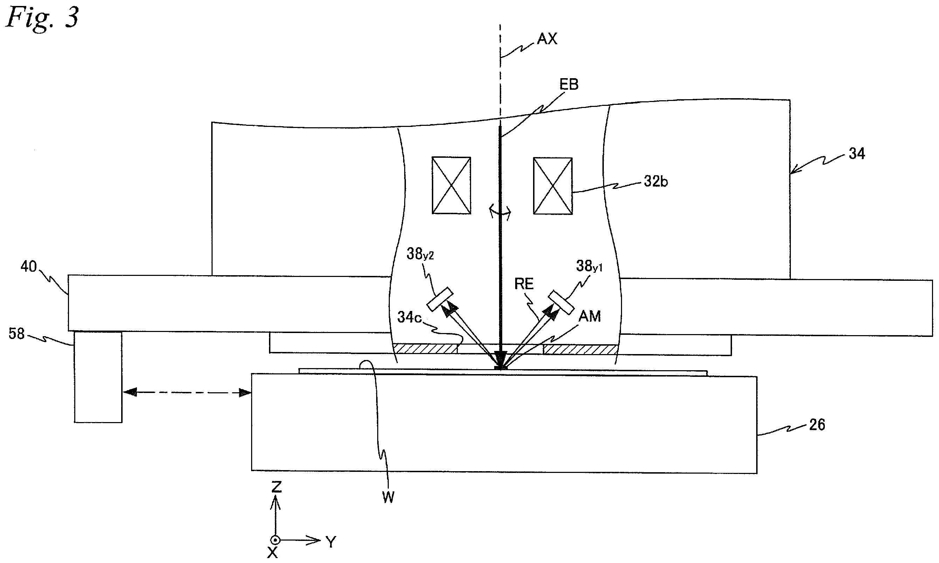

As illustrated in FIG. 3, the plurality of reflected electron detecting devices 38 are respectively provided at such positions as to be capable of detecting reflected electrons RE that are generated at an alignment mark AM on wafer W when electron beams EB are irradiated on alignment mark AM via opening 34c, and are incident into barrel 34 via opening 34c. Alignment mark AM formed on wafer W is formed by a two-dimensional mark including a line-and-space pattern with a period direction in the Y-axis direction and a line-and-space pattern with a period direction in the X-axis direction. Although only a pair of reflected electron detecting devices 38_{y1} and 38_{y2} are illustrated in FIG. 3 (and FIG. 2) that detect reflected electrons generated from alignment mark AM on wafer W in directions inclined with respect to the optical axis within the YZ plane, a pair of reflected electron detecting devices 38ₓ₁ and 38ₓ₂ are also provided in actuality that detect reflected electrons generated from alignment mark AM in directions inclined with respect to the optical axis within the XZ plane (see FIG. 8) .

In FIG. 4, a perspective view of stage device 22 is illustrated. Surface plate 14 equipped in stage device 22 is, in actuality, installed on the bottom wall of vacuum chamber 10 that divides the exposure chamber. As illustrated in FIG. 4, stage device 22 is equipped with: a coarse movement slider 22a that includes a pair of quadrangular prism shaped parts disposed spaced apart at a predetermined spacing in the Y-axis direction and each extending in the X-axis direction, and is movable with a predetermined stroke in the X-axis direction on surface plate 14; and stage 26 that is movable with a predetermined stroke relative to coarse movement slider 22a in the Y-axis direction and is also movable with a short stroke compared to the stroke in the Y-axis direction, in directions of remaining five degrees of freedom, i.e., the X-axis direction, the Z-axis direction, the θx direction, the θy direction and the θz direction. Note that, although omitted in the figures, the pair of quadrangular prism shaped parts of coarse movement slider 22a are coupled by a coupling member (not illustrated) and integrated, in actuality, in a state of not blocking the movement of stage 26 in the Y-axis direction.

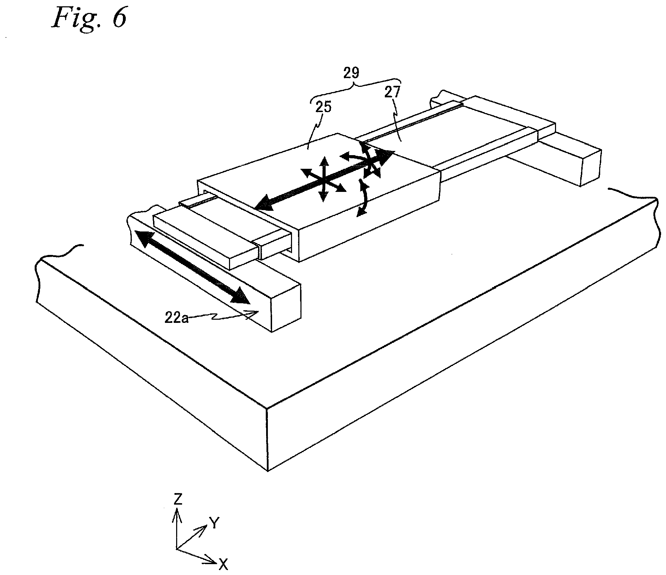

Coarse movement slider 22a is driven with a predetermined stroke in the X-axis direction (see a long arrow along the X-axis direction in FIG. 6) by a coarse movement slider driving system (not illustrated) . The coarse movement slider driving system is configured of, in the present embodiment, a uniaxial drive mechanism in which the magnetic flux leakage does not occur, e.g., a feed screw mechanism using a ball screw. This coarse movement slider driving system is disposed between one quadrangular prism shaped part of the pair of quadrangular prism shaped parts of coarse movement slider 22a and surface plate 14. For example, a configuration is employed in which a screw shaft is attached to surface plate 14 and a ball (a nut) is attached to the one quadrangular prism shaped part. Note that another configuration may also be employed in which a ball (a nut) is attached to surface plate 14 and a screw shaft is attached to the one quadrangular prism shaped part.

Further, the other quadrangular prism shaped part, of the pair of quadrangular prism shaped part of coarse movement slider 22a, is configured to move along a guide surface (not illustrated) provided at surface plate 14.

The screw shaft of the ball screw is rotated and driven by a stepping motor. Alternatively, the coarse movement slider driving system may be configured of a uniaxial drive mechanism equipped with an ultrasonic motor as a drive source. In either configuration, there is few risk that the magnetic field fluctuation caused by magnetic flux leakage affects the positioning of electron beams. The coarse movement slider driving system is controlled by a stage controller 70 (see FIG. 8).

Stage 26 includes, as illustrated in FIG. 4, a fine movement slider 22b and a flat plate shaped table TB fixed on the upper surface of fine movement slider 22b. Wafer W is adsorbed and held on table TB via an electrostatic chuck (not illustrated).

FIG. 5 shows a perspective view, when viewed from a angle different from FIG. 4, of the components of stage device 22, in which table TB is removed from stage device 22 illustrated in FIG. 4. As enlargedly illustrated in the perspective view of FIG. 5, fine movement slider 22b is made up of a member with a rectangular frame shaped XZ cross-section penetrating in the Y-axis direction, and is supported by a weight cancelling device 42 to be movable within the XY plane on surface plate 14. A plurality of stiffening ribs are provided on the outer surface of a side wall of fine movement slider 22b. Note that the configuration of weight cancelling device 42 will be described later.

Inside a hollow section of fine movement slider 22b, a yoke 25a with a rectangular frame shaped XZ cross-section extending in the Y-axis direction, and a pair of magnet units 25b fixed on the vertically facing surfaces of yoke 25a are provided, and yoke 25a and the pair of magnet units 25b configure a mover 25 of a motor that drives fine movement slider 22b.

Corresponding to mover 25, a stator 27 made up of a coil unit is stretched between the pair of quadrangular prism parts of coarse movement slider 22a, as illustrated in FIG. 6 that shows a state where table TB, fine movement slider 22b and a magnetic shield member (to be described later) denoted by a reference sign 28 are removed from FIG. 4. Note that, in FIG. 6, the illustration of weight cancelling device 42 is also omitted. Stator 27 and mover 25 described earlier configure a motor 29 of a closed magnetic field type and also of a moving magnet type that is capable of moving mover 25 with a predetermined stroke relative to stator 27 in the Y-axis direction as well as finely driving mover 25 relative to stator 27 in the X-axis direction the Z-axis direction, the θx direction, the θy direction and the θz direction, as indicated by arrows in the respective directions in FIG. 6. In the present embodiment, motor 29 configures a fine movement slider driving system that drives fine movement slider 22b in directions of six degrees of freedom. The fine movement slider driving system (electromagnetic motor 29) is controlled by stage controller 70 (see FIG. 8).

In the present embodiment, coarse movement slider 22a is driven with a predetermined stroke in the X-axis direction by the coarse movement slider driving system, and fine movement slider 22b and table TB, i.e., stage 26 is driven with a predetermined stroke in the Y-axis direction and also finely driven in the X-axis direction the Z-axis direction, the θx direction, the θy direction and the θz direction by the fine movement slider driving system. That is, the coarse movement slider driving system and the fine movement slider driving system configure stage driving system 24 (see FIG. 8) that drives stage 26 with the six degrees of freedom. Hereinafter, for the sake of convenience, this stage driving system 24 is assumed to be a single driving system that drives stage 26 with a predetermined stroke in the X-axis direction and the Y-axis direction and also finely drives stage 26 in the Z-axis direction, the θx direction, the θy direction and the θz direction, and stage driving system 24 is assumed to be controlled by stage controller 70.

For example, as illustrated in FIG. 4, magnetic shield member 28 with a reversed U-like shaped XZ cross-section is further stretched between the pair of quadrangular prism parts of coarse movement slider 22a, in a state of covering the upper surface and the both side surfaces in the X-axis direction of motor 29. That is, magnetic shield member 28 is formed extending in a direction (the Y-axis direction) intersecting a direction in which the quadrangular prism parts extend, and is equipped with an upper surface section facing the upper surface of motor 29 in a noncontact manner and side surface sections facing the side surfaces of motor 29 in a noncontact manner. Of the side surface sections of magnetic shield member 28, the lower surfaces of both ends in the longitudinal direction (the Y-axis direction) are fixed on the upper surfaces of the pair of quadrangular prism parts of coarse movement slider 22a, in a state where magnetic shield member 28 is inserted into the hollow section of fine movement slider 22b. Further, of the side surface sections of magnetic shield member 28, the other portions, than the lower surfaces of the both ends described above, face in a noncontact manner the bottom wall surface (the lower surface) of the inner wall surfaces of fine movement slider 22b. That is, magnetic shield member 28 is inserted into the hollow section of fine movement slider 22b, in a state not blocking the movement of mover 25 relative to stator 27.

As magnetic shield member 28, a laminate magnetic shield member that is configured of multiple layers of films of a magnetic material that are layered with a predetermined clearance (space) in between is used. In addition, such a magnetic shield member may be used that has a configuration in which films of two types materials having different magnetic permeabilities are alternately layered. Magnetic shield member 28 covers the upper surface and the side surfaces of motor 29 over the full length of the movement stroke of mover 25, and fixed to coarse movement slider 22a, and therefore the magnetic flux leaking upward (to the electron beam optical system side) can be suppressed in the entire area of the movement range of fine movement slider 22b and coarse movement slider 22a.

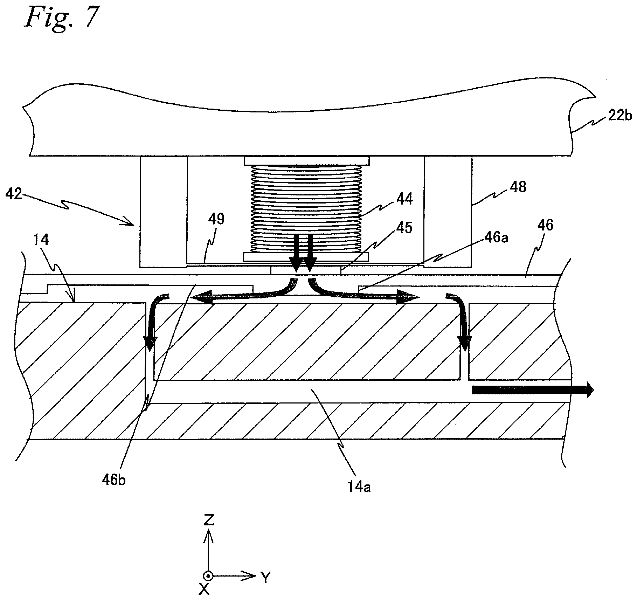

As illustrated in FIG. 7, weight cancelling device 42 has an air spring of a bellows type made of metal (hereinafter, simply referred to as an air spring) 44 having an upper end connected to the lower surface of fine movement slider 22b, and a base slider 46 made up of a flat plate member connected to the lower end of air spring 44. Air spring 44 and base slider 46 are connected to each other via a plate-shaped connecting member 45 with an opening formed in the center.

Base slider 46 is provided with a bearing section 46a, below air spring 44, that blows out air inside air spring 44 to the upper surface of surface plate 14, and the self-weight of the components of the upper part of base slider 46, i.e. , the self-weight of weight cancelling device 42 and stage 26 (including fine movement slider 22b, table TB and mover 25) is supported by the static pressure (the pressure in a gap) between the bearing surface of the pressurized air blown out from bearing section 46a and the upper surface of surface plate 14. Note that the compressed air is supplied to air spring 44 via a piping (not illustrated) connected to fine movement slider 22b.

On the surface (the lower surface) of base slider 46 facing surface plate 14, an ring-shaped recessed section 46b is formed around bearing section 46a, and corresponding to recessed section 46b, an exhaust passage 14a is formed for performing vacuum exhaust, toward outside, of the air blown out from bearing section 46a into a space divided by recessed section 46b and the upper surface of surface plate 14. Recessed section 46b of base slider 46 has such a size as to maintain a state in which the exhaust opening of exhaust passage 14 faces recessed section 46b wherever fine movement slider 22b is moved in a movable range within the XY plane on surface plate 14. That is, a kind of air static pressure bearing of a differential evacuation type is configured below base slider 46, and the air blown out from bearing section 46a toward surface plate 14 is prevented from leaking out around (into the exposure chamber).

A pair of support columns (pillars) 48 are fixed, with air spring 44 in between, on the lower surface of fine movement slider 22b. The pair of support columns 48 are disposed laterally symmetric with respect air spring 44 as the center, on both sides of air spring 44 in the Y-axis direction and each have the length in the Z-axis direction slightly longer than that of air spring 44. A pair of plate springs 49 with a U-like shape in planar view, whose one ends are connected to the lower end surface of air spring 44, have the other ends respectively connected to the respective lower ends of the pair of support columns 48. In this case, the pair of plate springs 49 have the respective U-like tips (forked portions) connected to air spring 44, and the opposite side ends respectively connected to the pair of support columns 48. The pair of plate springs 49 and base slider 46 are substantially parallel and a predetermined gap is formed between them.

Since the pair of plate springs 49 are capable of receiving a force in the horizontal direction acting on base slider 46 on the movement of fine movement slider 22b within the XY plane, an unnecessary force can be substantially reliably prevented from acting on air spring 44 on the movement of fine movement slider 22b within the XY plane. Further, when the tilt driving of fine movement slider 22b is performed, the pair of plate springs 49 is deformed to allow the tilt.

The position information of stage 26 (table TB) is measured by a laser interferometer system (hereinafter, simply referred to as an interferometer system) 58 provided at metrology frame 40, as illustrated in FIG. 2. Although, in actuality, interferometer system 58 has at least one X interferometer made up of a multiaxial interferometer, at least two Y interferometers made up of multiaxial interferometers, and at least one Z interferometer so that position of stage 26 in the directions of six degrees of freedom (the X-axis direction, the Y-axis direction, the Z-axis direction, the θx direction, the θy direction and the θz direction) can be measured, these interferometers are representatively shown as interferometer system 58 in the figures such as FIGS. 1 and 2.

The position information measured by interferometer system 58 is supplied to stage controller 70 and main controller 60 via stage controller 70 (see FIG. 8).

FIG. 8 shows, in a block diagram, the input/output relationship of main controller 60 that configures the control system of electron beam exposure apparatus 100. Main controller 60 includes a microcomputer and the like, and performs the overall control of the respective components of electron beam exposure apparatus 100 that includes the respective sections shown in FIG. 8.

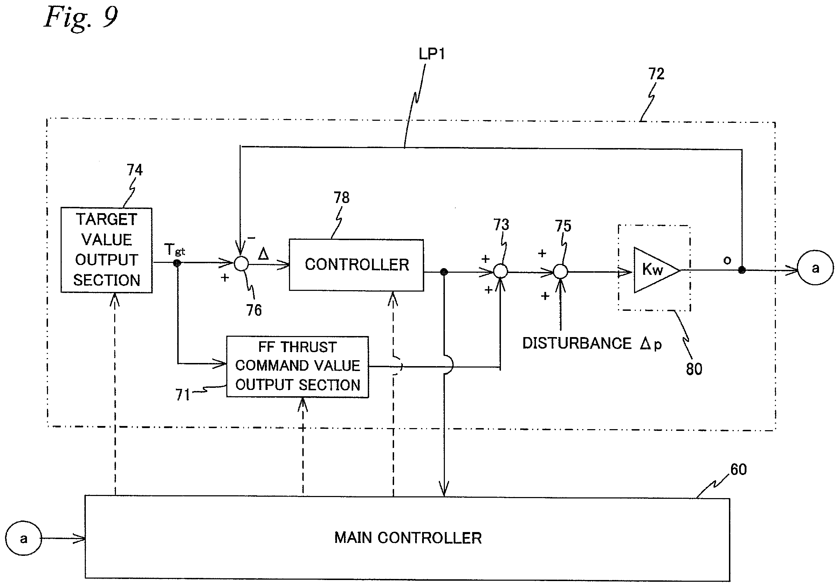

In FIG. 9, a block diagram of a stage controlling system 72 structured inside stage controller 70 is shown together with main controller 60. In FIG. 9, a stage system 80 to be controlled by stage controlling system 72 is shown inside stage controlling system 72 for convenience of explanation. Here, stage driving system 24, stage 26 that is driven in the directions of six degrees of freedom by stage driving system 24, and a position measurement system that measures the position of stage 26, which is interferometer system 58 in the present embodiment, substantially correspond to stage system 80. Although most of the respective blocks except for stage system 80 in FIG. 9 are embodied by means of software in actuality, at least a part of the component elements may be configured of the corresponding individual hardware as a matter of course.

As illustrated in FIG. 9, stage controlling system 72 is configured including a target value output section 74, a subtracter 76, a controller 78, a feedforward (FF) thrust command value output section 71, an adder 73, an adder 75 and the like.

In response to the instruction from main controller 60, target value output section 74 creates a position command profile with respect to stage 26, and generates a position command per unit time in the profile, i.e. , target values T_{gt} (= (Xₜ, Yₜ, 0, 0, 0, 0)) of the position of stage 26 in the respective directions of the X, Y, Z, θx, θy and θz (the directions of six degrees of freedom), and outputs the target values to each of subtracter 76 and FF thrust command value output section 71. Of the target values, a target value Xₜ of the position in the X-axis direction and a target value Yₜ of the position in the Y-axis direction are each generated on the basis of a mathematical function of a period of time t from a reference time using the accurate period of time from a clock section (not illustrated). A target value of the position in the Z-axis direction is a constant value when the surface of wafer W is caused to coincide with, for example, the center position in the Z-axis direction within a range of the depth of focus of electron beam optical system 32 after focus calibration of electron beam optical system 32 has been performed, and this position is assumed to be Z=0 in the present embodiment.

Subtracter 76 is used to compute a position deviation Δ (= (Δx=Xₜ-x, Δy=Yₜ-y, Δz=0-z, Δθx=0-θx, Δθy=0-θy, Δθz=0-θz) that is the difference between target values T_{gt} regarding the respective directions of degrees of freedom and the actually measured values in the respective directions of stage 26 (observation values o = (x, y, z, θx, θy, θz) corresponding to the measurement values of interferometer system 58). Here, observation values o corresponding to the measurement values of interferometer system 58 are fed back to subtracter 76.

Controller 78 includes: a PI controller that performs a (proportion plus integration) control operation individually with respect to the respective directions of degrees of freedom with the position deviation Δ from subtracter 76 serving as an operation signal, and computes command values of thrusts P (= (Pₓ, P_{y}, P_{z}, Pθₓ, Pθ_{y}, Pθ_{z})) in the respective directions of degrees of freedom; and the like. In the present embodiment, a control gain (a feedback control gain) of controller 78, specifically, a proportion gain (P gain) and an integration gain (I gain) of the PI controller can be switched (changed) at two stages of high and low by main controller 60. The proportion gain is changeable at two stages that are a first value (a first predetermined value) and a second value smaller than the first value (e.g. , a value that can be regarded as substantially zero), and the integration gain is changeable at two stages that are a third value (a second predetermined value) and a fourth value smaller than the third value (e.g., a value that can be regarded as substantially zero). The setting of the proportion gain to the first value and the integration gain to the third value is expressed as setting (or changing) the control gain to "high", and the setting of the proportion gain to the second value and the integration gain to the fourth value is expressed as setting (or changing) the control gain to "low" . The change of the control gain will be further described later.

FF thrust command value output section 71 is a section to obtain a thrust command value for maintaining the attitude (θx, θy, θz) of stage 26 to (θx, θy, θz) = (0, 0, 0) at all positions on the movement route of stage 26 on exposure of a wafer, in accordance with the position information of stage 26 in the X-axis direction and the Y-axis direction, which is (Xₜ, Yₜ) included in target values T_{gt} in this case, and to cause a position feedback control system (a position loop) LP1 to feedforward-input the thrust command values p (= (pₓ, p_{y}, p_{z}, pθₓ, pθ_{y}, pθ_{z})) via adder 73.

At the time of the exposure operation and the like, FF thrust command value output section 71 outputs the thrust command values p (= (pₓ, p_{y}, p_{z}, pθₓ, pθ_{y}, pθ_{z})) in accordance with the position (X, Y) of stage 26, on the basis of a position-thrust command value map obtained beforehand in accordance with target value T_{gt} from target value output section 74.

Inside FF thrust command value output section 71, a switch is provided that sets the output of thrust command values with respect to adder 73, to ON/OFF, and the switch is turned ON/OFF by main controller 60. This switch is normally in the ON state, and the thrust command values described above are output from FF thrust command value output section 71 to adder 73. Note that a method of obtaining the position-thrust command value map will be described later.

Adder 73 adds the thrust command value P from controller 78 and the thrust command value p from FF thrust command value output section 71 for each of the directions of degrees of freedom, and outputs to adder 75 a command value of thrust (P + p) after such addition has been made.

Adder 75 outputs the sum of the command value of thrust (P + p) and disturbance Δp to stage system 80 that is denoted by a thrust-position conversion gain Kw. Thrust-position conversion gain Kw expresses a series of phenomena, as a thrust-position conversion gain, in which stage 26 is driven as a result of a thrust being given to stage 26 via stage driving system 24 and thereby the position of stage 26 is changed, and the change of the position is measured by interferometer system 58, and then observation value o corresponding to the measurement value of interferometer system 58 is output. Note that adder 75 does not actually exist. However, disturbance Δp actually acts on stage 26 as a thrust. In order to express this action of disturbance Δp, adder 75 is provided for the sake of convenience in FIG. 9, so that disturbance Δp is given, along with the command value of thrust (P + p), to thrust-position conversion gain Kw via this adder 75. In FIG 9, observation value o is fed back from thrust-position conversion gain Kw to subtracter 76.

Note that, in FIG. 9, observation value o outputted from thrust-position conversion gain Kw is also sent to main controller 60.

Now, the method of obtaining the position-thrust command value map used by FF thrust command value output section 71 will be described.

First of all, main controller 60 turns OFF the switch described earlier within FF thrust command value output section 71, in a state of setting the control gain of controller 78 to "high", and also gives an instruction to target value output section 74 to output a target value with which stage 26 is moved below electron beam optical system 32 along a route in a direction reversed to route Rt of the center of the exposure area shown in FIG. 10 and is stopped at every movement of a predetermined distance (a minute distance) . Accordingly, the control (the feedback control) of the stage by stage controlling system 72 is started, and stage 26 is moved along the route in the direction reversed to route Rt of the center of the exposure area shown in FIG. 10 and is stopped at every movement of the predetermined distance.

Every time when stage 26 is stopped, main controller 60 takes in a command value of thrust outputted from controller 78 (on this occasion, the control gain is set to "high") and a measurement value of interferometer system 58 (observation value o) simultaneously, and matches the thrust command value and the position of stage 26 (the measurement value of interferometer system 58) and captures them into a memory (not illustrated). The simultaneous taking-in of the command value of thrust outputted from controller 78 and the measurement value of interferometer system 58 as described above is repeatedly performed at each stop position of stage 26 until the relative movement along route Rt of the center of the exposure area with respect to the entire surface of the wafer is finished. Accordingly, information on the position coordinates (X, Y) of stage 26 and the corresponding thrust command values is stored in the memory, and the position-thrust command value map described earlier can be created from these pieces of information. Main controller 60 forwards (stores) the position-thrust command value map into a memory of FF thrust command value output section 71, and returns the switch described earlier within FF thrust command value output section 71 to the ON state.

Meanwhile, in the present embodiment, in the case where the control gain of controller 78 is set (changed) to "low", the thrust command value from controller 78 is substantially zero, and the input to adder 73 is substantially only the feedforward input from FF thrust command value output section 71 in accordance with target value T_{gt} (the thrust command value based on the position-thrust command value map). Consequently, compared to the case where the control gain of controller 78 is "high", a remarkably small thrust command value is given from adder 73 to stage driving system 24 of stage system 80 via adder 75, and the control of stage 26 by stage driving system 24 is performed. On this occasion, if electron beam irradiation device 30 is in a state of irradiating wafer W with an electron beam, a displacement (a position displacement) of the irradiation position of the electron beam on wafer W occurs due to the fluctuation in the electromagnetic field by the driving of motor 29. However, in the case where the only the thrust command value from FF thrust command value output section 71 is given to stage driving system 24, a thrust component having a high frequency and a large amplitude caused by the high response feedback control disappears from a force generated by motor 29, and a relatively smooth component mainly having a low frequency and a small amplitude derived from the target trajectory (target value T_{gt} of the position from target value output section 74) becomes dominant. Thus, the displacement amount of the irradiation position of the electron beam on wafer W generated due to the fluctuation in the electromagnetic field is originally small.

Further, in this case, since the thrust command value given to the stage driving system is based on the position-thrust command value map, the thrust command value is unambiguously determined in accordance with the position coordinate (X, Y) of stage 26. Consequently, the displacement of the irradiation position on the wafer of the electron beam caused by the fluctuation in the electromagnetic field by the thrust generated by motor 29 according to such the thrust command value is also unambiguously determined, in accordance with the position coordinate (X, Y) of stage 26. The displacement of the irradiation position on the wafer of the electron beam in this case corresponds to the deflection (the displacement of the angle of the beam with respect to the optical axis) and the shift (a displacement within the XY plane) of the electron beam. With regard to the former, focus adjustment is generally performed beforehand so that there is no focus displacement of the electron beam along the optical axis, and therefore in the case where the beam is inclined with respect to the optical axis, the wafer surface is displaced from the best focus position of the inclined beam, and the displacement of the irradiation position on the wafer surface of the electron beam, in proportion to the difference in height between the best focus position of the beam and the wafer surface, and the inclination angle, occurs. That is, the deflection of the electron beam appears as the displacement of the irradiation position on the wafer of the electron beam, in a similar manner to the shift of the electron beam.

Therefore, in the present embodiment, a map (a position-irradiation position displacement map) that shows the relationship between the position coordinate of stage 26 and the displacement of the irradiation position on the wafer of electron beam EB, for correcting the displacement of the irradiation position on the wafer of the electron beam in accordance with the position coordinate (X, Y) of stage 26, is created beforehand and is stored in a memory equipped in main controller 60.

This position-irradiation position displacement map is created in, for example, the following procedures.

First of all, a wafer for measurement is loaded onto stage 26, in a state where the orientation of the wafer for measurement is adjusted so that a rotational displacement between a wafer coordinate system that is a two-dimensional orthogonal coordinate system with, for example, the center of the wafer for measurement serving as the origin, and a stage coordinate system that is a two-dimensional orthogonal coordinate system defined by length measurement axes of interferometer system 58 is zero.

Next, main controller 60 positions stage 26 at a position where a reference mark whose positional relationship with the origin on the wafer for measurement is known is located directly under the optical axis of electron beam irradiation device 30. Then, main controller 60 sets the position of wafer W in the Z-axis direction to the same position at the time of exposure, scans the reference mark on the wafer for measurement while changing the focus position by changing the electric current of the focus coil that focus lens 32a described earlier has, via focus controlling section 64, and from the change in the detection signal of reflected electron detecting device 38 (a predetermined one of reflected electron detecting devices 38ₓ₁, 38ₓ₂, 38_{y1} and 38_{y2}) that detects the reflected electrons, obtains the position when the change is most radical as an optimal focus position, and afterwards supplies the electric current corresponding to such an optimal focus position to the focus coil.

When the initial setting (the initial adjustment) of the focus of electron beam EB as described above is finished, the position coordinate (X, Y) of the reference mark described above is obtained on the stage coordinate system, on the basis of the detection signal of reflected electron detecting device 38 (38ₓ₁, 38ₓ₂, 38_{y1}, 38_{y2}) and the measurement value of interferometer system 58, and thereby the positional relationship between the wafer coordinate system and the stage coordinate system is obtained and stored in a memory.

After the preparatory works as described above, main controller 60 performs exposure, similar to exposure of a wafer for device manufacturing, with respect to the wafer for measurement. Specifically, a pattern is drawn while moving the wafer for measurement (stage 26) in, for example, a direction reversed to route Rt of the exposure area center shown FIG. 10. This exposure of (the drawing of the pattern on) the wafer for measurement is performed by repeating an alternate scan operation in which scanning exposure of the wafer for measurement is performed in the +Y direction and the -Y direction alternately serving as the scanning direction, and an operation (a stepping operation) in which the wafer for measurement (stage 26) is moved along a distance corresponding to the width of the exposure area in the X-axis direction to one side in the X-axis direction during deceleration and acceleration of the wafer for measurement (stage 26) in the Y-axis direction between the +Y direction scanning (plus scan) and the -Y direction scanning (minus scan).

Now, the exposure operation of the wafer for measurement will be further described.

On the exposure operation of the wafer for measurement, as is described above, main controller 60 gives the command to target value output section 74 to output the position command so that stage 26 repeats the alternate scan operation and the stepping operation described above. Accordingly, stage 26 (wafer W) repeats the alternate scan operation and the stepping operation so that the center of the exposure area is moved relative to wafer W along the route as shown in FIG. 10.

When the center of the exposure area is located at acceleration starting position (exposure staring position) STA, stage 26 is in a stop state, and the feedback control gain of controller 78 is set to "high". The plus can of stage 26 is started from this state. On this plus scan, target value T_{gt} (= (X, Y, 0, 0, 0, 0)) of the position from target value output section 74 is given to FF thrust command value output section 71 and subtracter 76, the position deviation Δ is computed at subtracter 76 and sent to controller 78. Accordingly, controller 78 starts the proportion plus integration control operation using the position deviation as the operation signal, and the command value of thrust to zero the position deviation is computed every moment and is given to one input end of adder 73. To the other input end of adder 73, the command value of thrust in accordance with target value T_{gt} (= (X, Y, 0, 0, 0, 0)) of the position from FF thrust command value output section 71 is given. Then, adder 73 adds the command value of thrust P and the command value of thrust p from FF thrust command value output section 71, and adder 75 further adds disturbance Δp, and the added value (P + p + Δp) is given to stage system 80 as the thrust command value, and thereby stage 26 is accelerated in the +Y direction by stage driving system 24.

Then, when the acceleration of the stage in the +Y direction is finished and a target velocity is attained, main controller 60 switches the control gain of controller 78 from "high" to "low". Main controller 60 detects that the target velocity is attained on the basis of the monitor results of observation value o. By switching the control gain from "high" to "low", the position control of stage 26 is switched (from the feedback control and the feedforward control) to the feedforward control (the control of feedforward-inputting, to adder 73, the thrust command value according to the position-thrust command value map in accordance with target value T_{gt}). Here, in a state where the control gain is switched to "low", stage 26 is moved at a constant speed in the Y-axis direction mainly according to the law of inertia. Consequently, it can be said that the feedforward control on this occasion is a control for causing stage driving system 24 to generate a driving force required to maintain the attitude (the position in the θx direction, the θy direction and the θz direction) of stage 26 to (0, 0, 0).

As is described above, substantially simultaneously with the switching of the control gain from "high" to "low", main controller 60 starts the irradiation of electron beam EB to the wafer for measurement by electron beam irradiation device 30 while monitoring observation value o, thereby starting the scanning exposure (the plus scan exposure) of the wafer for measurement. The plus scan exposure is performed during the constant speed movement of stage 26 in the +Y direction, and during this constant speed movement, stage 26 is moved in the +Y direction mainly according to the law of inertia as is described earlier. Note that the minus scan exposure is similar to the plus scan exposure though the movement direction of the stage is the reversed Y direction.

However, it is difficult to maintain the attitude (θx, θy, θz) of stage 26 to (0, 0, 0) during the movement in the Y-axis direction across a plurality of shots, by the movement only according to the law of inertia, and therefore, the feedforward control based on the position-thrust command value map described earlier is performed.

Then, when the constant speed movement period of stage 26 is finished, main controller 60 switches the FB control gain from "low" to "high", and also stops the irradiation of electron beam EB from electron beam irradiation device 30. Further, by switching the FB control gain from "low" to "high", the feedback control and the feedforward control of the position of stage 26 are resumed, and the stepping operation along the U-like route of stage 26 (wafer W) is started.

When the stepping operation is finished, at this point in time, the acceleration of stage 26 in the reversed direction along the Y-axis direction (the -Y direction) is finished and the target velocity is attained, and therefore main controller 60 switches the control gain of controller 78 from "high" to "low". Accordingly, the position control of stage 26 is switched (from the feedback control and the feedforward control) to the feedforward control, and the driving of stage 26 in the -Y direction is switched from the driving by the thrust of stage driving system 24 (motor 29 and the like) to the motion mainly according to the law of inertia. Further, target value T_{gt} that causes stage 26 to perform the constant speed movement at the target velocity along the -Y direction is given from target value output section 74 to subtracter 76 and FF thrust command value output section 71, and the scanning exposure similar to the foregoing one is performed. After that, the stepping and the scanning exposure by alternate scan in which the plus scan and the minus scan are alternately repeated are alternately and repeatedly performed in a manner similar to the manner described above.

After the wafer for measurement exposed in the manner described above is developed, the position displacement of resist images (e.g., mark images formed at equal intervals within each shot area) of the wafer for measurement is measured across the entire surface of wafer W, and thereby a map is created that shows the relationship between each position (x_{w}, y_{w}) on the coordinate system on the wafer for measurement (the wafer coordinate system) and the displacement of the irradiation position according to such each position.

Then, by converting each position (x_{w}, y_{w}) on the coordinate system on the wafer for measurement (the wafer coordinate system) into each position (X, Y) on the corresponding stage coordinate system on the basis of the positional relationship between the wafer coordinate system and the stage coordinate system at the time of exposure of the wafer for measurement that is stored in the memory of main controller 60, the map (the position-irradiation position displacement map) can be obtained that shows the relationship between the position coordinate of stage 26 and the displacement of the irradiation position on the wafer of electron beam EB.

In electron beam exposure apparatus 100, according to predetermined pattern data and each drawing parameter determined beforehand, main controller 60 controls electron beam EB emitted from electron beam optical system 32 and stage 26, and performs exposure (pattern drawing) to wafer W.

Meanwhile, multiple layers of patterns need to be overlaid and formed on the wafer until a micro device such as a semiconductor device is completed, and the overlaying between the patterns of base layers and the patterns to be drawn is important.

Therefore, in the present embodiment, prior to the pattern drawing to the wafer (the exposure of the wafer), main controller 60 sequentially scans electron beam EB with respect to two or more alignment marks AM (see FIG. 3) formed beforehand on the wafer by controlling deflection lens 32b via electron ray deflection controlling section 66, and detects reflected electrons generated from alignment marks AM at the time of such scanning with reflected electron detecting devices 38. At the time of scanning with respect to alignment marks AM, the acceleration voltage of electron beam EB is set to the same as the acceleration voltage at the time of the exposure (at the time of the pattern drawing).

FIG. 3 shows, as an example, reflected electrons RE that are directed from alignment marks AM to reflected electron detecting device 38_{y1} and 38_{y2} by electron beam EB irradiated to alignment marks AM along an optical path parallel to the optical axis (the optical path indicated in solid line in the figure). On the basis of deflection information (including information on deflection angles, deflection directions and the like) of electron rays obtained from electron ray deflection controlling section 66 and the processing results of detection signals of the marks obtained from signal processor 62, main controller 60 identifies the positions of alignment marks AM, and on the basis of the positions and stage coordinate information obtained from interferometer system 58 at the time of detection, main controller 60 obtains the positions of alignment marks AM on the stage coordinate system. On the basis of the positions of the two or more alignment marks on the stage coordinate system obtained in this manner, target position information can be obtained for positioning the shot area on a wafer at the exposure position (the irradiation position in a reference state of the electron beam, i.e., the irradiation position on wafer W of electron beam EB when electron beam EB is irradiated along the optical path shown in solid line in FIG. 3 on optical axis AX). Then, at the time of exposure of the wafer (at the time of drawing a pattern to the wafer), main controller 60 draws a pattern while moving the wafer (stage 26) on the basis of the acquired target position information. By using alignment marks AM as a reference, the pattern can constantly be drawn at a desired position, and thereby a pattern to be newly drawn is well overlaid on patterns already formed on wafer W.

However, for example, during measurement of the positions of alignment marks AM (wafer alignment measurement), if the position of electron beam EB is displaced (such as a displacement of the deflection angle, or a displacement of the deflection direction) from the reference state, e.g., a state where the optical path of electron beam EB coincides with optical AX of electron beam optical system 32, because of the magnetic field fluctuation due to the driving of motor 29, an error occurs in the measurement results of the positions of alignment marks AM (referred to as an alignment measurement error), which will lead to an error being included in the target position information described earlier that is obtained on the basis of such positions of alignment marks AM. Therefore, in the present embodiment, in order to prevent the situation in which such an error is included in the target position information from occurring, measurement of mark position information of alignment marks AM (alignment measurement) is performed as follows.

On this alignment measurement, main controller 60 gives the instructions to target value output section 74 to output target values with which, of a plurality of alignment marks AM provided at a plurality of shot areas on a wafer, a predetermined number selected beforehand, e.g., about 10 to 20, of alignment marks AM are sequentially positioned directly under electron beam optical system 32 (the irradiation position on wafer W of electron beam EB) and stopped at each of such positions. Accordingly, according to the target values outputted from target value output section 74, the movement of stage 26 is controlled by stage controlling system 72 and the predetermined number of alignment marks AM are sequentially positioned directly under electron beam optical system 32 and stage 26 is stopped at each of the positions.

However, when alignment marks AM are sequentially positioned directly under electron beam optical system 32 and stage 26 is stopped, main controller 60 switches the control gain of controller 78 from "high" to "low". Consequently, at each stop position, regarding stage 26, the feedforward control of the position, in which a thrust command value according to the position-thrust command value map described earlier is given to stage system 80 via adder 73, is performed (substantially, without the feedback control of the position) . In the present embodiment, main controller 60 is capable of correcting the irradiation position displacement of electron beam EB on the basis of the position-irradiation position displacement map.

Therefore, each time when stage 26 is positioned directly under electron beam optical system 32 and stopped, main controller 60 performs the position measurement of alignment marks AM (the alignment measurement) using electron beam irradiation device 30. On this measurement, while monitoring the measurement values of interferometer system 58, main controller 60 performs control of deflection lens 32b by electron ray deflection controlling section 66 on the basis of the position-irradiation position displacement map, thereby performing the measurement of alignment marks AM in a state where the irradiation position displacement of the electron beam on the wafer is corrected. Accordingly, the highly accurate alignment measurement can be performed that prevents the occurrence of the measurement error in the positions of alignment marks AM because of variation in electron beam EB caused by the magnetic field fluctuation at the time of the measurement.

Then, main controller 60 obtains the target position information for positioning the shot areas on a wafer W at the exposure position on the basis of results of this alignment measurement, as described earlier, and draws patterns while moving the wafer (stage 26) in, for example, a direction reversed to route Rt of the exposure area center shown in FIG. 10, on the basis of the acquired target position information. Note that this exposure operation of the wafer is similar to the exposure operation with respect to the wafer for measurement described earlier in detail, and therefore the detailed description will be omitted.

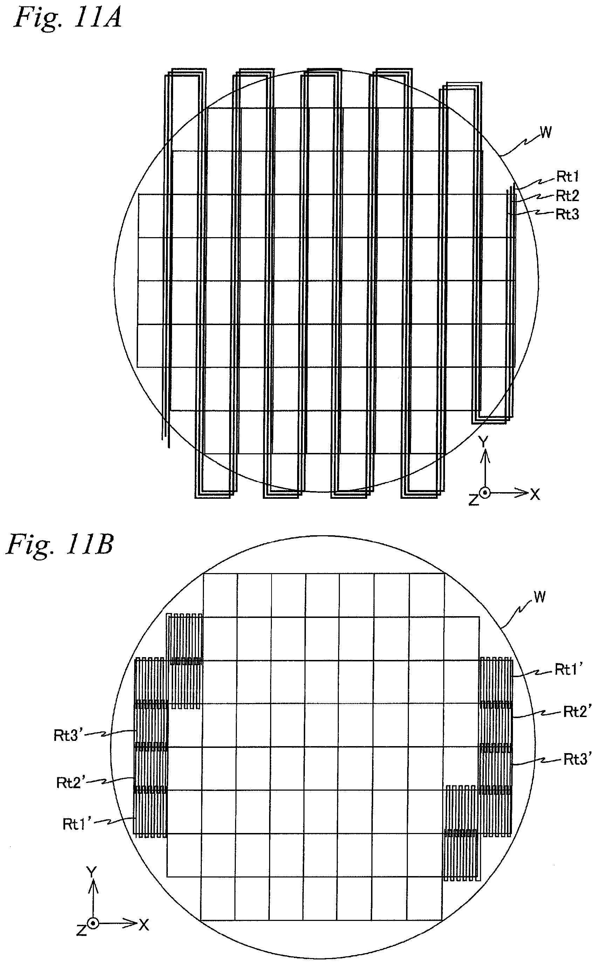

Note that, in the above description, the case has been described where the exposure is performed while moving stage 26 so that the charged particle beam (the exposure area) is moved relative to stage 26 along route Rt shown in FIG. 10, this is not intended to be limiting, and as illustrated in FIG. 11A, all shot areas on a wafer may be exposed, by exposing, first of all, a part of each of all shot areas along a route Rt1, and then exposing another part of each of all the shot areas along a route Rt2 that is shifted by 10µm to the -X side from route Rt1, and further exposing yet-another part of each of all the shot areas along a route Rt3 that is shifted by 10µm to the -X side from route Rt2, and so on. Further, as illustrated in FIG. 11B, such an exposure operation may be performed that, first of all, exposes the entirety of one shot area along a route Rtl', and then sequentially exposes the respective shot areas along routes Rt2', Rt3' and so on. In the case of employing either routes, the switching between "high" and "low" of the feedback control gain of stage controlling system 72 is performed between during the constant speed movement in the Y-axis direction of stage 26 in which the scanning exposure is performed and during the acceleration/deceleration in the Y-axis direction of stage 26 in which the stepping operation is performed. Further, when the control gain is switched to "low", the feedforward control of the position (substantially, without the feedback control of the position), in which the thrust command value according to the position-thrust command value map described earlier is given to stage system 80 via adder 73, should be performed and also the irradiation position displacement of electron beam EB should be corrected on the basis of the position-irradiation position displacement map.

As is clear from the description so far, in the present embodiment, stage controlling system 72 structured in stage controller 70 configures a control system that controls stage driving system 24, and main controller 60 and stage controller 70 configure a control system that controls electron beam irradiation device 30 and stage driving system 24.

As is described above, in electron beam exposure apparatus 100 related to the present embodiment, for example, when the scanning exposure to a wafer is performed, main controller 60 sets the feedback control gain of stage controlling system 72 structured inside stage controller 70 (the control gain of controller 78) to "low", i.e., a value that can be regarded as substantially zero, during the constant speed movement of stage 26 in the Y-axis direction (the scanning direction at the time of the scanning exposure) in which the scanning exposure is performed, and sets the feedback control gain to "high" at the time of the acceleration/deceleration in the Y-axis direction in which the stepping operation is performed. In the case where the feedback control gain is set to "low", the feedforward control with respect to stage driving system 24 that feedforward-inputs, to adder 73, a thrust command value according to the position-thrust command value map acquired beforehand in accordance with target value T_{gt} of the position from target value output section 74, but the feedback control with respect to stage driving system 24 is not performed. Therefore, the output of motor 29 at the time of the constant speed movement of stage 26 is remarkably smaller than the output of motor 29 at the time of the acceleration/deceleration of stage 26.

Consequently, in electron beam exposure apparatus 100, stage 26 is driven by stage driving system 24 including motor 29 at the time of the acceleration/deceleration in the Y-axis direction, and stage 26 is moved mainly according to the law of inertia at the time of the constant speed movement. Therefore, it is possible to suppress the deflection (the position displacement) of electron beam EB of electron beam optical system 32 by the magnetic field fluctuation that occurs due to motor 29 generating a driving force during the scanning exposure of a wafer.

In addition, in the present embodiment, main controller 60 corrects the displacement of the irradiation position on wafer W of electron beam EB of electron beam optical system 32 caused by the magnetic field fluctuation when only the feedforward control with respect to stage driving system 24 is performed, by controlling deflection lens 32b via electron ray deflection controlling section 66, on the basis of the position-irradiation position displacement map acquired beforehand in accordance with target value T_{gt} of the position from target value output section 74. Therefore, the irradiation position displacement of electron beam EB can be prevented from occurring due to the magnetic field fluctuation generated by the driving of stage 26 during the scanning exposure.

Further, in the present embodiment, at the time of measurement such as the wafer alignment measurement in which electron beam EB is irradiated from electron beam optical system 32 to alignment marks AM on a wafer and reflected electrons from these alignment marks AM are measured using reflected beam detecting device(s) 38 (at least one of reflected beam detecting devices 38ₓ₁, 38ₓ₂, 38_{y1} and 38_{y2}), the irradiation of the electron beam is performed during the stop of the wafer (stage 26). Therefore, in a similar manner to the time of the scanning exposure described above, the irradiation position displacement of electron beam EB can be prevented from occurring due to the magnetic field fluctuation.

Note that, in the embodiment described above, the case has been described where the control gain of the feedback control system that configures stage controlling system 72 is changed, and thereby stage 26 is driven using stage driving system 24 at the time of the acceleration/deceleration in the scanning direction (the Y-axis direction) and stage 26 is moved mainly according to the law of inertia at the time of the constant speed movement. However, this is not intended to be limiting, and by turning ON/OFF a switch which opens/closes a circuit and which is provided between controller 78 and adder 73, the supply and the stop of the supply of the output of controller 78 to adder 73 may be controlled. Also with this control manner, stage 26 can be driven using stage driving system 24 at the time of the acceleration/deceleration in the scanning direction (the Y-axis direction) and stage 26 can be moved mainly according to the law of inertia at the time of the constant speed movement, similarly to the embodiment described above.

Further, in the embodiment described above, the case has been described where the "low" level of the feedback control gain is a level that can be regarded as substantially zero, but depending on the configuration and the performance of the magnetic shield with respect to the electromagnetic motor that the stage driving system has, there may be a configuration capable of more effectively suppressing the influence that magnetic field fluctuation exerts on the electron beam. Consequently, the "low" level is not necessarily limited to the level that can be regarded as substantially zero, but only has to be a level lower than the "high" level.

Further, in the embodiment described above, the case has been described where the feedback control gain of the position control system (position loop LP1) is changed between the irradiation time of the electron beam and the non-irradiation time of the electron beam (or, between the case where the acceleration of a stage in the scanning direction is zero (during the constant speed movement or during the stop of the stage), and the case where the acceleration is non-zero). However, this is not intended to be limiting, and for example, in the case where the stage controlling system is configured of a multiplex loop control system that includes a velocity loop as a minor loop of the position loop, the feedback control gain of the velocity loop may be changed. In short, the control gain of at least a part of the control system should be changed so that the influence, that the magnetic field fluctuation caused by the thrust generation of the electromagnetic motor configuring the stage driving system exerts on the electron beam emitted from the electron beam optical system, is smaller at the irradiation time of the electron beam than at the non-irradiation time, or so that such the influence at the time of the constant speed movement of the stage in the scanning direction (the Y-axis direction the embodiment above) is smaller than at the time of the acceleration/deceleration of the stage in the scanning direction.

Further, in the embodiment described above, the case has been exemplified where the feedforward control for maintaining the attitude of stage 26 is performed, at the time when the feedback control of the stage driving system is not performed, such as at the time of the constant speed movement on the plus scan or the minus scan. However, both of the feedback control and the feedforward control of the stage driving system need not be performed at the time of the constant speed movement of the stage or the like, when employing an apparatus configuration in which the attitude of the stage can be maintained without the stage driving system generating the thrust.

Further, in the embodiment described above, the exposure is to be performed with respect to a wafer for measurement and the position measurement of the resist images is to be performed after development of the wafer for measurement that has been exposed, and thereby the map (the position-irradiation position displacement map) that shows the relationship between the position of the stage and the irradiation position displacement of the electron beam on the wafer for measurement is to be created. However, this is not intended to be limiting, and for example, a reference mark may be formed on the inner side of the emitting end of barrel 34, and the position of this reference mark may be detected at each position (X, Y) of stage 26, and thereby map information that shows the relationship between information on the variation in the electron beam (the angle displacement with respect to the optical axis and the position displacement within the XY plane) caused by the fluctuation in the electromagnetic field of motor 29 generated at the time of driving of the stage, and the position of stage 26 may be obtained, and at least one of the irradiation position and the irradiation angle of the electron beam with respect to the wafer may be adjusted on the basis of this map information. For example, the step movement of stage 26 is performed at predetermined intervals along a route similar to that for the exposure, and the feedforward control of the stage driving system according to the position-thrust command value map without the feedback control is performed at each step position, similarly to the time when the alignment described above is performed. Then, at each step position, the reference mark of barrel 34 is scanned with electron beam EB from electron beam optical system 32, and reflected electrons from the reference mark are detected with reflected electron detecting device(s) 38, and thereby information on the variation in electron beam EB (the angle displacement with respect to the optical axis and the position displacement within the XY plane) is obtained, and thus the map information described above may be obtained.

Further, in the embodiment described above, the adjustment of the irradiation position of the electron beam with respect to a target such as a wafer for measurement or a wafer is to be performed by deflection control of the electron beam via electron ray deflection controlling section 66. However, this is not intended to be limiting, and the feedforward control of stage driving system 24 may be performed in order to adjust the irradiation position on the target of the electron beam that is caused by at least one of the irradiation position and the irradiation angle of the electron beam on the target. Such the feedforward control can be performed, for example, as follows.
a. First of all, in the procedures described earlier, the exposure with respect to a wafer for measurement, the position displacement measurement of resist images formed on the wafer for measurement that has been exposed (e.g., mark images formed at equal intervals within each shot area), and the like are performed, and a map (a position-irradiation position displacement map) that shows the relationship between the position coordinate of stage 26 and a displacement in the irradiation position (the irradiation position displacement) on the wafer of electron beam EB is acquired. Next, a difference δp (= (δpₓ, δp_{y}, δp_{z}, δpθₓ, δρθ_{y}, δpθ_{z})) of a thrust command value with respect to stage driving system 24 that corresponds to the irradiation position displacement in accordance with the position coordinate of stage 26 included in this position-irradiation position displacement map is obtained, and a thrust command value p (= (pₓ, p_{y}, p_{z}, pθₓ, δpθ_{y}, pθ_{z})) included in a position-thrust command value map created before is updated (p+δp→p) to a new thrust command value (p+δp).
b. Then, the exposure is performed with respect to the wafer for measurement in the procedures similar to the previous procedures, while controlling the driving of stage 26 using the updated thrust command value p as a thrust command value to be given (to be feedforward-inputted) from FF thrust command value output section 71 to adder 73. Then, a new position-irradiation position displacement map is obtained, by the position displacement measurement of the resist images formed on the wafer for measurement that has been exposed, and coordinate conversion based on the positional relationship between the wafer coordinate system and the stage coordinate system at the time of exposure of the wafer for measurement.
c. Then, the judgement is made as to whether the position displacement included in the new position-irradiation position displacement map (i.e., the position displacement that could not completely be corrected, and hereinafter referred to as a residual position displacement) becomes a value of a level that can substantially be ignored. In the case where this judgement is affirmed, the update of the position-thrust command value map is finished. On the other hand, in the case where the above judgement is denied, the processes of the following d. and e. are repeated until the residual position displacement becomes a value of a level that can substantially be ignored.
d. A difference δp (= (δpₓ, δρ_{y}, δp_{z}, δpθₓ, δpθ_{y}, δpθ_{z})) of a thrust command value with respect to stage driving system 24 that corresponds to the residual position displacement is obtained, and a thrust command value p (= (pₓ, p_{y}, p_{z}, pθₓ, δpθ_{y}, pθ_{z})) included in the latest position-thrust command value map is updated (p+δp→p) to a new thrust command value (p+δρ).
e. Then, the exposure is performed with respect to the wafer for measurement in the procedures similar to the previous procedures, while controlling the driving of stage 26 using the updated thrust command value p as a thrust command value to be given (to be feedforward-inputted) from FF thrust command value output section 71 to adder 73. Then, a new position-irradiation position displacement map is obtained, by the position displacement measurement of the resist images formed on the wafer for measurement that has been exposed (e.g., the mark images formed at equal intervals within each shot area), and coordinate conversion based on the positional relationship between the wafer coordinate system and the stage coordinate system at the time of exposure of the wafer for measurement.
f. Then, the exposure operation of the wafer is performed in the procedures described earlier. However, in this exposure operation, the feedforward control of stage driving system 24 is performed on the basis of the latest position-thrust command value map (i.e., the position-thrust command value map at the point in time when the residual position displacement becomes a value of a level that can substantially be ignored). In this case, since the irradiation position displacement of the electron beam with respect to the wafer is adjusted by the feedforward control of stage driving system 24, the deflection control of the electron beam via electron ray deflection controlling section 66 becomes unnecessary.

Note that, in the foregoing processes a. to e., it is premised that, by repeating a plurality of times the processes d. and e. after the processes a. to c., the position-thrust command value map, with which the irradiation position displacement of the electron beam with respect to the wafer can be adjusted by the feedforward control of stage driving system 24 without fail, can be obtained.

However, as the number of repetition times of the foregoing processes d. and e. increases, the difference between the thrust command value in the position-thrust command value map obtained finally and the thrust command value in the position-thrust command value map obtained first increases. If this difference excessively increases, it is predicted to be difficult to maintain the attitude of stage 26, for example, during the constant speed movement in which the scanning exposure is performed. This is because, in the first place, the thrust command value in the position-thrust command value map obtained first is the thrust command value in accordance with the position of stage 26 for maintaining the attitude of stage 26.

Therefore, the restriction is imposed on the number of repetition times described above, and in the case where the position-thrust command value map, with which the residual position displacement becomes a value of a level that can substantially be ignored, cannot be obtained by the repetition of the restricted number of times, α·δp that is obtained by multiplying the difference δp of the thrust command value described earlier (the difference to update the thrust command value) by an attenuation factor α (α is an arbitrary value from 0 to 1) may be used, instead of the difference δp described above.

Moreover, the feedforward control of stage driving system 24 for adjusting the irradiation position of the electron beam on the target may be performed on the basis of map information that shows the relationship between information on the variation of electron beam EB described above (the angle displacement with respect to the optical axis and the position displacement within the XY plane) and the position of stage 26.

Note that, although the case has been described, in the embodiment described above, where main controller 60 changes the control content with respect to the stage driving system between the irradiation time and the non-irradiation time of the electron beam on the wafer (the target), this is not intended to be limiting, and stage driving system 24 (including electromagnetic motor 29) described above may be controlled on the basis of the irradiation state of the electron beam on the wafer (the target) . For example, the irradiation time of the electron beam is divided into a plurality of states, and for example, the feedback control gain may be differentiated for each of the states. For example, the stage driving system may be controlled by differentiating the feedback control gain between the exposure time and the alignment measurement time. Further, the feedback control gain may be continuously variable depending on the magnitude of an energy amount of the electron beam irradiated on the wafer.

Note that, in the embodiment described above, since the feedback control of the stage driving system is not performed at the irradiation time of the electron beam, the generated thrust of the stage driving system at that time is remarkably small, compared to the time of performing the feedback control of the stage driving system (e.g., the non-irradiation time of the electron beam) . Consequently, the stage driving system is not limited to the combination of motor 29 and the uniaxial drive mechanism but may be configured of a planar motor and the like.

Note that, although the case of using electron beam optical system 32 of a single column type has been exemplified in the embodiment described above, this is not intended to be limiting and an electron beam optical system of a multicolumn type that has a plurality of optical system columns made up of the multibeam optical systems described earlier may be used.

Note that, for the multibeam optical system related to the embodiment described above, a method of drawing a pattern on a specimen surface by generating a plurality of electron beams via a blanking aperture array having a plurality of openings and individually setting the electron beams to ON/OFF in accordance with the drawn pattern may be employed as a method of setting each beam to ON/OFF. Further, instead of the blanking aperture array, a configuration of using a surface emission type electron beam source having a plurality of electron emitting sections that emit a plurality of electron beams may be employed. Further, as the electron beam irradiation device, an electron beam irradiation device of a method of using variable shaped beams (rectangular beams) in which the shape of an electron ray is changed into a rectangular shape by causing the electron ray to pass several rectangular holes called shaping apertures.

Note that, although the case has been described, in the embodiment described above, where exposure system 20 as a whole is accommodated inside vacuum chamber 10, this is not intended to be limiting, and parts of exposure system 20, excluding the lower end of barrel 34 of electron beam irradiation device 30, may be exposed on the outside of vacuum chamber 10.

Note that although, in the embodiment described above, electron beam irradiation device 30 is to be integral with metrology frame 40 and supported in a suspended manner from the top plate (the ceiling wall) of the vacuum chamber via the three suspension support mechanisms 50a, 50b and 50c, this is not intended to be limiting, and electron beam irradiation device 30 may be supported by a body of a floor mount type. Further, a configuration may be employed in which electron beam irradiation device 30 is movable relative to stage 26.

Note that, in the embodiment described above, the case has been described where the target is a wafer for semiconductor device manufacturing, but the electron beam exposure apparatus related to the embodiment described above can suitably be applied also when masks are manufactured by forming fine patterns on glass substrates. For example, it may also be employed in exposure systems such as an exposure system that draws a mask pattern on a rectangular glass plate or a silicon wafer, or an exposure system for manufacturing organic ELs, thin-film magnetic heads, imaging devices (such as CCD), micromachines, DNA chips or the like. Further, although the electron beam exposure apparatus that uses electron beams as charged particle beams has been described in the embodiment described above, the embodiment described above can also be applied to an exposure apparatus using ion beams or the like as charged particle beams for exposure.

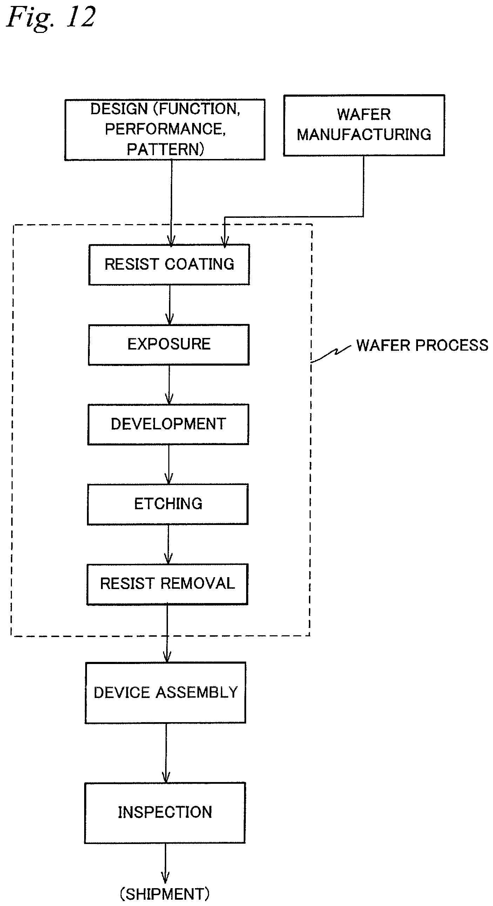

As shown in FIG. 12, electron devices such as semiconductor devices are manufactured through the steps such as: a step in which the function/performance design of a device is performed; a wafer manufacturing step in which wafer is manufactured of a silicon material; a wafer processing step in which an actual circuit and the like are formed on the wafer by lithography techniques; a device assembly step (including a dicing process, a bonding process and packaging process); and an inspection step. The wafer processing step includes the steps such as: a step in which a resist (a sensitive agent) is coated on the wafer; an exposure step in which exposure (the drawing of patterns according to the designed pattern data) is performed with respect to the wafer by the electron beam exposure apparatus of the embodiment described earlier and the exposure method thereof; a development step in which the wafer that has been exposed is developed; an etching step in which an exposed member of the other section than a section where resist remains is removed by etching; and a resist removal step in which the resist that is no longer necessary when etching is completed is removed. In this case, in the exposure step, the exposure method described earlier is implemented using the exposure apparatus in the embodiment described above and a device pattern is formed on the wafer, and therefore, the micro devices with a high integration degree can be manufactured with high productivity.

Incidentally, the disclosures of all the publications (including the PCT International Publications) related to exposure apparatuses and the like that are cited above are each incorporated herein by reference.

### INDUSTRIAL APPLICABILITY

As is described above, the exposure apparatus related to the present invention is suitable to be used in the lithography process in the manufacturing of electron devices such as semiconductor devices.

### REFERENCE SIGNS LIST

- 24: stage driving system,
- 26: stage,
- 28: magnetic shield,
- 29: motor,
- 30: electron beam irradiation device,
- 60: main controller,
- 70: stage controller,
- 72: stage controlling system,
- 100: exposure apparatus,
- LP1: position loop,
- W: wafer.

## Claims

1. An exposure apparatus comprising an irradiation device that irradiates a target with a charged particle beam, the apparatus comprising:
a stage that holds the target;
a stage driving system that includes an electromagnetic motor to drive the stage; and
a control system that controls the irradiation device and the stage driving system, wherein
the control system controls the stage driving system based on an irradiation state of the charged particle beam on the target.

2. The exposure apparatus according to claim 1, wherein
the control system changes a control content with respect to the stage driving system between an irradiation time and a non-irradiation time of the charged particle beam on the target.

3. The exposure apparatus according to claim 2, wherein
the control system includes a feedback control system that controls the stage driving system, and
the change of the control content with respect to the stage driving system includes changing a control gain of the feedback control system between the irradiation time and the non-irradiation time of the charged particle beam on the target.

4. The exposure apparatus according to claim 3, wherein
the control gain of the feedback control system at the irradiation time of the charged particle beam is set to a value smaller than the control gain of the feedback control system at the non-irradiation time of the charged particle beam.

5. The exposure apparatus according to claim 4, wherein
the control gain of the feedback control system at the irradiation time of the charged particle beam is set to a value that can be regarded as substantially zero.

6. The exposure apparatus according to any one of claims 1 to 5, wherein
in order to adjust an irradiation position on the target of the charged particle beam caused by a fluctuation in an electromagnetic field of the electromagnetic motor generated at a time of driving of the stage, the control system performs a feedforward control of the stage driving system.

7. The exposure apparatus according to claim 6, wherein
when adjusting the irradiation position by the feedforward control, the control system gives control information in accordance with a position of the stage, to the stage driving system.

8. The exposure apparatus according to claim 6 or 7, wherein
the adjustment of the irradiation position on the target of the charged particle beam is performed based on map information that shows a relationship between information on a variation in the charged particle beam and a position of the stage, the variation in the charged particle beam being caused by the fluctuation in the electromagnetic field of the electromagnetic motor generated at the time of driving of the stage.

9. The exposure apparatus according to any one of claims 1 to 8, wherein
irradiation of the charged particle beam on the target is performed in a state where acceleration of the stage is zero.

10. The exposure apparatus according to claim 9, wherein
the irradiation of the charged particle beam on the target is performed during constant speed movement of the stage.

11. An exposure apparatus that exposes a target with a charged particle beam while moving the target in a predetermined direction, the apparatus comprising:
a stage that holds the target;
an irradiation device that irradiates the target with the charged particle beam;
a stage driving system that includes an electromagnetic motor to drive the stage; and
a control system that drives the stage using the stage driving system at a time of acceleration/deceleration of the stage in the predetermined direction, and performs movement of the stage including a motion mainly according to the law of inertia at a time of constant speed movement of the stage in the predetermined direction.

12. The exposure apparatus according to claim 11, wherein
an output of the electromagnetic motor at the time of the constant speed movement of the stage is smaller than an output of the electromagnetic motor at the time of the acceleration/deceleration of the stage.

13. The exposure apparatus according to claim 11 or 12, wherein
the control system includes a feedback control system that controls the stage driving system, and
a control gain of the feedback control system at the time of the constant speed movement of the stage is set to a value smaller than the control gain of the feedback control system at time of the acceleration/deceleration of the stage.

14. The exposure apparatus according to claim 13, wherein
the control gain of the feedback control system at the time of the constant speed movement of the stage is set to a value that can be regarded as substantially zero.

15. The exposure apparatus according to claim 13 or 14, wherein
control information in accordance with a position of the stage can be feedforward-inputted to the stage driving system.

16. The exposure apparatus according to claim 15, wherein
the control information is acquired beforehand, based on a control result of the feedback control system obtained when the stage is driven along a predetermined route.

17. The exposure apparatus according to any one of claims 1 to 16, wherein
a magnetic shield is provided to the electromagnetic motor.

18. A device manufacturing method, comprising:
exposing a substrate as a target with a charged particle beam, using the exposure apparatus according to any one of claims 1 to 17; and
developing the substrate that has been exposed.

19. A control method of an exposure apparatus comprising a stage that holds a target and an irradiation device that irradiates the target with a charged particle beam, the method comprising:
controlling a stage driving system and the irradiation device, the stage driving system including an electromagnetic motor to drive the stage, wherein
in the controlling, the stage driving system is controlled based on an irradiation state of the charged particle beam on the target.

20. The control method according to claim 19, wherein
in the controlling, a control content with respect to the stage driving system is changed between an irradiation time and a non-irradiation time of the charged particle beam on the target.

21. The control method according to claim 20, wherein
the change of the control content with respect to the stage driving system includes changing a control gain of a feedback control system between the irradiation time and the non- irradiation time of the charged particle beam on the target, the feedback control system controlling the stage driving system.

22. The control method according to claim 21, wherein
the control gain of the feedback control system at the irradiation time of the charged particle beam is set to a value smaller than the control gain of the feedback control system at the non-irradiation time of the charged particle beam.

23. The control method according to claim 22, wherein
the control gain of the feedback control system at the irradiation time of the charged particle beam is set to a value that can be regarded as substantially zero.

24. The control method according to any one of claims 19 to 23, wherein
in the controlling, in order to adjust an irradiation position on the target of the charged particle beam caused by a fluctuation in an electromagnetic field of the electromagnetic motor generated at a time of driving of the stage, a feedforward control of the stage driving system is performed.

25. The control method according to claim 24, wherein
when adjusting the irradiation position by the feedforward control, the control system gives control information in accordance with a position of the stage, to the stage driving system.

26. The control method according to claim 23 or 25, wherein
the adjustment of the irradiation position on the target of the charged particle beam is performed based on map information that shows a relationship between information on a variation in the charged particle beam and a position of the stage, the variation in the charged particle beam being caused by the fluctuation in the electromagnetic field of the electromagnetic motor generated at the time of driving of the stage.

27. The control method according to any one of claims 19 to 26, wherein
in the controlling, the irradiation device and the stage driving system are controlled so that acceleration of the stage becomes zero, at an irradiation time of the charged particle beam on the target.

28. The control method according to claim 27, wherein
the irradiation device and the stage driving system are controlled so that the irradiation of the charged particle beam on the target is performed during constant speed movement of the stage.

29. A control method of controlling an exposure apparatus that exposes a target with a charged particle beam from an irradiation device while moving the target in a predetermined direction, the method comprising:
controlling a stage driving system that includes an electromagnetic motor to drive a stage that holds the target, wherein
in the controlling, the stage is driven using the stage driving system at a time of acceleration/deceleration of the stage in the predetermined direction, and movement of the stage including a motion mainly according to the law of inertia is performed at a time of constant speed movement of the stage in the predetermined direction.

30. The control method according to claim 29, wherein
in the controlling, a control gain of a feedback control system at the time of the constant speed movement of the stage is set to a value smaller than the control gain of the feedback control system at the time of the acceleration/deceleration of the stage, the feedback control system controlling the stage driving system.

31. The control method according to claim 30, wherein
the control gain of the feedback control system at the time of the constant speed movement of the stage is set to a value that can be regarded as substantially zero.

32. The control method according to claim 30 or 31, wherein
control information in accordance with a position of the stage is further feedforward-inputted to the stage driving system.

33. The control method according to claim 32, wherein
the control information is acquired beforehand, based on a control result of the feedback control system obtained when the stage is driven along a predetermined route.
